# EUROPÄISCHE PATENTSCHRIFT

(11) **EP 2 329 538 B1**
(45) Veröffentlichungstag und Bekanntmachung des Hinweises auf die Patenterteilung: **20.02.2019**
(21) Anmeldenummer: 09776123.3
(22) Anmeldetag: 31.08.2009
(51) Int. Cl.: H01L 33/48, H01L 33/62

(54) **GEHÄUSE FÜR EIN OPTOELEKTRONISCHES BAUTEIL**
HOUSING FOR AN OPTOELECTRONIC COMPONENT
BOÎTIER POUR COMPOSANT OPTOÉLECTRONIQUE

(30) Priorität: 22.09.2008 DE 102008048259
(43) Veröffentlichungstag der Anmeldung: 08.06.2011
(73) Patentinhaber: OSRAM Opto Semiconductors GmbH, 93055 Regensburg (DE)
(72) Erfinder: ARNDT, Karlheinz, 93077 Bad Abbach (DE)
(74) Vertreter: Epping - Hermann - Fischer
(86) Internationale Anmeldenummer: PCT/DE2009/001223
(87) Internationale Veröffentlichungsnummer: WO 2010/031373

(56) Entgegenhaltungen:
- EP-A- 0 200 462
- EP-A- 0 400 175
- EP-A- 1 858 089
- WO-A-2007/141664
- WO-A2-94/11929
- DE-A1- 19 931 122
- JP-A- S6 055 676
- JP-A- H06 163 991
- JP-A- H07 211 937
- JP-A- 2002 368 285
- US-A- 5 116 229
- US-A- 5 122 045
- US-A1- 2006 001 133
- US-A1- 2007 029 563
- US-A1- 2008 225 532
- US-B1- 6 344 689

## Beschreibung

Es wird ein Gehäuse angegeben, das insbesondere für ein seitlich emittierendes Bauteil, einen so genannten Seitenemitter, geeignet ist. Ferner wird ein Verfahren zur Herstellung eines derartigen Gehäuses angegeben.

Seitlich emittierende Bauteile sind beispielsweise aus den Druckschriften WO 2007/141664, EP 0200462, EP 1858089, EP 0400175 und US 5,116,229 bekannt.

Eine zu lösende Aufgabe besteht vorliegend darin, ein Gehäuse mit verbesserter Stabilität anzugeben.

Eine weitere zu lösende Aufgabe besteht darin, ein einfaches Verfahren zur Herstellung eines derartigen Gehäuses anzugeben. Diese Aufgaben werden durch ein Gehäuse gemäß Patentanspruch 1 und ein Verfahren gemäß Patentanspruch 13 gelöst.

Vorteilhafte Ausgestaltungen und Weiterbildungen des Gehäuses und des Herstellungsverfahrens sind in den jeweiligen abhängigen Ansprüchen angegeben.

Gemäß einer bevorzugten Ausführungsform ist das Gehäuse aus einem Gehäusekörper sowie einem ersten und einem zweiten Anschlussstreifen gebildet. Der erste und zweite Anschlussstreifen sind insbesondere zur elektrischen Versorgung eines optoelektronischen Halbleiterchips vorgesehen, der in dem Gehäuse angeordnet werden kann. Darüber hinaus sind die Anschlussstreifen mit Vorteil dafür geeignet, die im Betrieb entstehende Verlustwärme aus dem Gehäuse abzuführen.

Der Gehäusekörper weist eine erste Seitenfläche auf, die quer, das heißt nicht parallel, zu einer Vorderseite und einer Rückseite des Gehäusekörpers angeordnet ist. Die Anschlussstreifen verlaufen teilweise innerhalb des Gehäusekörpers und sind an der ersten Seitenfläche aus dem Gehäusekörper herausgeführt. Außerhalb des Gehäusekörpers sind die Anschlussstreifen derart abgewinkelt, dass sie einen ersten Abschnitt, der sich quer, vorzugsweise senkrecht, zur ersten Seitenfläche erstreckt, und einen zweiten Abschnitt aufweisen, der sich in einem Abstand entlang der ersten Seitenfläche erstreckt. Ferner weist das Gehäuse Stützelemente auf, die mit dem Gehäusekörper verbunden sind und aus der Ebene der ersten Seitenfläche herausragen. Die Stützelemente sind dafür gedacht, das Gehäuse auf der Seite der Anschlussstreifen abzustützen. Vorzugsweise sind die Stützelemente einstückig mit dem Gehäusekörper ausgebildet.

Die Stützelemente weisen eine langgestreckte Form auf und erstrecken sich von der Vorderseite bis zur Rückseite des Gehäusekörpers. Dies sorgt für eine stabile Lage des Gehäuses auf einem Anschlussträger.

Durch die Stützelemente ist ein tunnelartiger Hohlraum ausgebildet, in welchem sich die Anschlussstreifen befinden. Weiterhin verlaufen die Stützelemente parallel zu den zweiten Abschnitten der Anschlussstreifen, wobei die Anschlussstreifen zwischen den Stützelementen angeordnet sind. Die Anschlussstreifen liegen an der Vorderseite des Gehäusekörpers frei, was eine Begutachtung des Fügemittels, insbesondere der Lötkehle, nach der Montage des Gehäuses ermöglicht. Dies erlaubt eine verbesserte Qualitätskontrolle.

Bei einer vorteilhaften Ausgestaltung des Gehäuses ist der Abstand zwischen der ersten Seitenfläche und den zweiten Abschnitten der Anschlussstreifen zwischen 0,4 mm und 0,6 mm groß. Insbesondere beträgt der Abstand 0,5 mm.

Der erste und der zweite Anschlussstreifen sind vorzugsweise parallel zueinander angeordnet. Weiterhin erstrecken sie sich mit Vorteil sowohl innerhalb als auch außerhalb des Gehäusekörpers in einer gemeinsamen Ebene. Darüber hinaus weisen die Anschlussstreifen insbesondere nicht mehr als eine Krümmung auf.

Der Erfindung liegt insbesondere der Gedanke zugrunde, dass für die Langzeitstabilität des Bauteils der Wärmeabtransport aus dem Bauteil gut funktionieren muss, um wärmebedingte Schäden zu verringern.

In diesem Zusammenhang erweisen sich verhältnismäßig dicke Anschlussstreifen als vorteilhaft. Vorzugsweise sind die Anschlussstreifen mindestens 0,2 mm dick. Besonders bevorzugt weisen die Anschlussstreifen eine Dicke von mindestens 0,3 mm auf.

Geeignete Materialien für die Anschlussstreifen sind Metalle, Metallverbindungen oder Metall enthaltende Materialien. Vorzugsweise sind die Anschlussstreifen aus einer Kupferlegierung gebildet. Besonders bevorzugt bestehen die Anschlussstreifen aus CuCrSiTi (K75).

Geeignete Materialien für den Gehäusekörper sind Kunststoffe, insbesondere Thermoplaste. Da diese leicht verformbar sind, wirkt sich der durch die dickeren Anschlussstreifen verbesserte Wärmeabtransport besonders vorteilhaft auf die Langzeitstabilität des Gehäusekörpers aus. Vorzugsweise wird für den Gehäusekörper Polyphtalamid (PPA) verwendet.

Das Gehäuse ist vorteilhafterweise oberflächenmontierbar, das heißt es kann auf einer Leiterplatte oder einem sonstigen Anschlussträger montiert und an diesen drahtlos elektrisch angeschlossen werden. Hierfür wird das Gehäuse so auf den Anschlussträger aufgesetzt, dass die erste Seitenfläche dem Anschlussträger zugewandt ist. Die beiden Anschlussstreifen sind dann ebenfalls dem Anschlussträger zugewandt, wobei insbesondere die zweiten Abschnitte der Anschlussstreifen entlang des Anschlussträgers verlaufen. Mithilfe eines Fügemittels, beispielsweise einem Lot, können die zweiten Abschnitte der Anschlussstreifen mit dem Anschlussträger sowohl mechanisch als auch elektrisch verbunden werden.

Gemäß einer vorteilhaften Weiterbildung schließen die zweiten Abschnitte der Anschlussstreifen mit dem Anschlussträger einen Winkel ein, der größer ist als 0°. Vorzugsweise beträgt der Winkel zwischen 1° und 2°. Der Winkel zwischen dem jeweiligen ersten und zweiten Abschnitt ist dabei größer als 90°. Dies hat zur Folge, dass die zweiten Abschnitte leicht schräg zum Anschlussträger verlaufen, wodurch ein kleiner Zwischenraum zwischen den zweiten Abschnitten und dem Anschlussträger ausgebildet ist, in welchem sich mit Vorteil das Fügematerial ansammeln und somit für eine gute Haftvermittlung zwischen Anschlussstreifen und Anschlussträger sorgen kann.

Gemäß einer vorteilhaften Ausführungsform weisen die Stützelemente eine Höhe auf, die mindestens dem Abstand der zweiten Abschnitte zur ersten Seitenfläche plus der Dicke der Anschlussstreifen entspricht. Somit ragen die Stützelemente mindestens soweit wie die Anschlusstreifen aus der Ebene der ersten Seitenfläche heraus. Insbesondere liegt das Gehäuse nicht an den Anschlussstreifen, sondern an den Stützelementen auf einem Anschlussträger auf. Dies erleichtert eine ebene Anordnung des Gehäuses auf dem Anschlussträger unabhängig vom Verlauf der Anschlussstreifen. Die Lage des Gehäuses relativ zum Anschlussträger kann durch die Stützelemente festgelegt werden. Somit wirkt sich beispielsweise ein leicht schräger Verlauf der Anschlussstreifen relativ zum Anschlussträger nicht negativ auf die Lage des Gehäuses aus.

Gemäß einer bevorzugten Ausführungsform sind die beiden Anschlussstreifen durch einen Spalt voneinander getrennt, der insbesondere außerhalb des Gehäusekörpers kleiner ist als die Breite der Stützelemente. Somit können sich die Stützelemente eines Gehäuses beim Transport mehrerer Gehäuse nicht zwischen den Anschlussstreifen eines anderen Gehäuses verhaken.

Bei einer vorteilhaften Ausgestaltung weist der Gehäusekörper auf der Rückseite einen Hohlraum auf. Dies hat fertigungsbedingte Vorteile. Insbesondere kann auf diese Weise bei der Herstellung des Gehäusekörpers mittels Spritzguss die Bildung von Lunkern reduziert werden.

Ferner erstrecken sich die Anschlussstreifen mit Vorteil bis in den Hohlraum. Auf die Anschlussstreifen kann somit von der Rückseite aus zugegriffen werden. Beispielsweise ermöglicht dies auch noch nach der Montage des Gehäuses auf einen Anschlussträger die Nachbearbeitung der Lötverbindung.

Der Hohlraum wird durch eine Rückwand sowie eine zweite, dritte und vierte Seitenwand des Gehäuserkörpers begrenzt. Eine nach außen weisende Seitenfläche der zweiten Seitenwand, die als zweite Seitenfläche bezeichnet wird, ist parallel zur ersten Seitenfläche angeordnet. Mit Vorteil ragt die zweite Seitenwand über die Anschlussstreifen hinaus und bildet somit für diese eine Abdeckung, so dass die Anschlussstreifen von oben geschützt sind. Weiterhin dient die zweite Seitenfläche als Ansaugfläche, an der das Gehäuse beim Verbauen angepackt wird. Um dabei ungünstige Verkippungen des Gehäuses zu vermeiden, weist die zweite Seitenfläche mit Vorteil eine quadratische Form auf. Die dritte und vierte Seitenwand sind quer, vorzugsweise senkrecht, zur ersten Seitenwand angeordnet. Diese Seitenwände sind nicht geschlossen, sondern weisen Durchbrüche auf, die insbesondere in den rückseitigen Hohlraum des Gehäusekörpers führen. Die Durchbrüche der dritten und vierten Seitenwand liegen einander mit Vorteil gegenüber, so dass problemlos eine Halterung durch die Durchbrüche geschoben werden kann. Die Halterung kann das Gehäuse beispielsweise bei der Befestigung eines Bonddrahtes stabilisieren.

Gemäß einer bevorzugten Ausführungsform weist der Gehäusekörper auf der Vorderseite eine Ausnehmung auf, die zur Aufnahme eines optoelektronischen Halbleiterchips vorgesehen ist. Ein innerhalb des Gehäusekörpers verlaufender Fortsatz des ersten Anschlussstreifens ragt mit Vorteil in die Ausnehmung hinein. Der Halbleiterchip kann auf dem Fortsatz angeordnet und mit diesem elektrisch verbunden werden. Weiterhin kann eine die Ausnehmung seitlich begrenzende Innenwand eine Vertiefung aufweisen, in welcher ein Teil des zweiten Anschlussstreifens freiliegt. Mit diesem Teil kann der Halbleiterchip mittels eines Bonddrahtes verbunden werden.

Bei einer bevorzugten Variante eines seitlich emittierenden Bauteils weist dieses ein Gehäuse gemäß einem der oben beschriebenen Ausgestaltungen und einen innerhalb des Gehäusekörpers angeordneten Strahlung emittierenden Halbleiterchip auf, wobei das Bauteil auf einem Anschlussträger angeordnet ist derart, dass sich die zweiten Abschnitte der Anschlussstreifen entlang des Anschlussträgers erstrecken und durch ein elektrisch leitendes Fügemittel mit dem Anschlussträger verbunden sind. Die Hauptabstrahlrichtung des Bauteils verläuft parallel zum Anschlussträger. Die Emission aus dem Gehäusekörper erfolgt auf der Vorderseite, das heißt auf der Seite der Ausnehmung.

Der Strahlung emittierende Halbleiterchip weist zur Strahlungserzeugung eine aktive Zone mit einem pn-Übergang auf. Dieser pn-Übergang kann im einfachsten Fall mittels einer p-leitenden und einer n-leitenden Halbleiterschicht gebildet sein, die unmittelbar aneinandergrenzen. Bevorzugt ist zwischen der p-leitenden und der n-leitenden Schicht die eigentliche Strahlung erzeugende Struktur, etwa in Form einer dotierten oder undotierten Quantenstruktur, ausgebildet. Die Quantenstruktur kann als Einfachquantentopfstuktur (SQW, Single Quantum Well) oder Mehrfachquantentopfstruktur (MQW, Multiple Quantum Well) oder auch als Quantendraht oder Quantenpunktstruktur ausgebildet sein.

Der Halbleiterchip enthält vorzugsweise ein Verbindungshalbleitermaterial wie AlₙGaₘIn₁₋ₙ₋ₘP oder AlₙGaₘIn₁₋ₙ₋ₘN, wobei 0 ≤ n ≤ 1, 0 ≤ m ≤ 1 und n+m ≤ 1 ist.

Gemäß einer bevorzugten Variante eines Verfahrens zur Herstellung eines wie oben beschriebenen Gehäuses wird ein Anschlussrahmen mit einem ersten und einem zweiten ebenen Anschlussstreifen in eine formgebende Vorrichtung eingebracht, wobei jeweils ein erster und ein zweiter Abschnitt der Anschlussstreifen aus der Vorrichtung herausragen. Weiterhin wird die Vorrichtung mit einer Gehäusekörpermasse zur Ausbildung des Gehäusekörpers befüllt, so dass die Anschlussstreifen zumindest teilweise in die Gehäusekörpermasse eingebettet werden. Die Anschlussstreifen werden vor oder nach der Fertigstellung des Gehäusekörpers mit einer Krümmung versehen, so dass jeweils der erste Abschnitt quer zum zweiten Abschnitt verläuft.

Der Anschlussrahmen weist einen rahmenartigen Bereich auf, der den ersten und zweiten Anschlusstreifen einrahmt. Jeder Anschlussstreifen ist mittels zweier Verbindungsstege mit dem rahmenartigen Bereich verbunden. Nach der Herstellung des Gehäusekörpers werden die Verbindungsstege von dem rahmenartigen Bereich abgetrennt. Die beiden Anschlussstreifen hängen dann nicht mehr zusammen. Sie sind als separate Elemente teilweise in den Gehäusekörper eingebettet. Die Lösung der Verbindung zwischen den Anschlussstreifen ist wichtig, damit bei einem Betrieb des Bauteils kein Kurzschluss auftritt.

Das Gehäuse wird vorzugsweise in Serienproduktion hergestellt, was zu einer kostengünstigen Herstellung des Gehäuses führt. Hierfür wird mit Vorteil ein Anschlussrahmenverbund mit mehreren Anschlussrahmen verwendet. Beispielsweise kann der Anschlussrahmenverbund ein Endlosband sein.

Bei einer vorteilhaften Ausführung des Verfahrens wird der Gehäusekörper mittels eines Spritzgussverfahrens hergestellt. Vorzugsweise wird als Gehäusekörpermasse ein Kunststoffmaterial verwendet. Besonders bevorzugt wird der Gehäusekörper aus einem Thermoplastmaterial hergestellt.

Im Hinblick auf eine Serienproduktion des Gehäuses ist das Spritzgussverfahren besonders vorteilhaft. Hierbei kann der bereits beschriebene Anschlussrahmenverbund in eine Spritzgussmaschine mit mehreren formgebenden Vorrichtungen eingebracht werden. Die formgebenden Vorrichtungen werden mit der Gehäusekörpermasse befüllt, und es werden einzelne Gehäusekörper ausgebildet. Nach der Fertigstellung der Gehäusekörper kann der Anschlussrahmenverbund vereinzelt werden, so dass einzelne Gehäuse vorliegen.

Bei der Herstellung eines seitlich emittierenden Bauelements findet die Vereinzelung in einzelne Bauelemente vorzugsweise erst nach der Befestigung des Halbleiterchips im Gehäuse statt. Insbesondere wird der Anschlussrahmenverbund nach der Herstellung des Gehäusekörpers entweder als Endlosband belassen oder in etwa 20 cm lange Streifen geschnitten, wobei jeder einzelne Streifen mehrere Anschlussrahmen aufweist.

Die Anschlussstreifen können vor oder nach der Herstellung des Gehäusekörpers mit einer Krümmung versehen werden. Insbesondere wird die Krümmung durch Biegen der Anschlussstreifen verursacht.

Werden die Anschlussstreifen nach der Herstellung des Gehäusekörpers gebogen, so können die Anschlussstreifen im Bereich der ersten Abschnitte derart eingeklemmt werden, dass beim Biegen keine Kräfte in den Gehäusekörper geleitet werden. Damit können Beschädigungen am Gehäuse verringert werden. Insbesondere wenn die Kräfte wie im Falle von dickeren Anschlussstreifen groß werden, erweist sich das Einklemmen als vorteilhafte Maßnahme.

Werden die Anschlussstreifen vor der Herstellung des Gehäusekörpers gebogen, so hat dies den Vorteil, dass später auf den Gehäusekörper keine Biegekräfte ausgeübt werden müssen und somit keine Beschädigungen des Gehäuses durch Biegekräfte zu befürchten sind. Allerdings kann sich das Umformen der abgewinkelten Anschlussstreifen mit der Gehäusekörpermasse komplizierter gestalten. Denn im Bereich der Krümmung der Anschlussstreifen ist es schwierig, die formgebende Vorrichtung so abzudichten, dass keine Gehäusekörpermasse aus der Vorrichtung austritt. Die ersten Abschnitte erstrecken sich deshalb vorzugsweise parallel zu einer Ebene, in welcher die Vorrichtung schließt. Dadurch kann die Vorrichtung im Bereich der ersten Abschnitte so dicht verschlossen werden, dass bei der Herstellung des Gehäusekörpers keine Masse aus der Vorrichtung austritt.

Weitere Vorteile und vorteilhafte Ausgestaltungen ergeben sich aus den folgenden Erläuterungen in Verbindung mit den Figuren 1 bis 8.

Es zeigen:
Figuren 1 bis 4 eine schematische Darstellung verschiedener Schritte einer bevorzugten Variante eines Verfahrens zur Herstellung eines Gehäuses,
Figuren 5 bis 8 verschiedene schematische Ansichten eines bevorzugten Ausführungsbeispiels eines Gehäuses.

In den Ausführungsbeispielen und Figuren sind gleiche oder gleich wirkende Bestandteile mit den gleichen Bezugszeichen versehen.

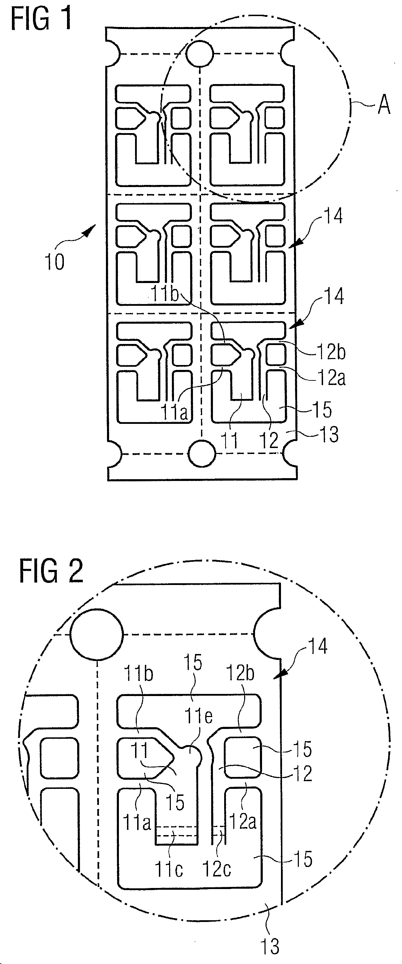

Figur 1 zeigt die Herstellung eines Anschlussrahmenverbunds 10. Hierbei werden mittels Stanzen in ein ebenes Metallblech Öffnungen 15 eingebracht (vergleiche auch Figur 2). Das Metallblech wird so ausgestanzt, dass mehrere zusammenhängende Anschlussrahmen 14 ausgebildet werden. Das Metallblech enthält insbesondere eine Kupferlegierung, vorzugsweise CuCrSiTi (K75).

Jeder Anschlussrahmen weist jeweils einen ersten Anschlussstreifen 11 und einen zweiten Anschlussstreifen 12 sowie einen rahmenartigen Bereich 13 auf, der die beiden Anschlussstreifen 11, 12 einrahmt. Der erste Anschlussstreifen 11 ist mittels zweier Verbindungsstege 11a, 11b mit dem rahmenartigen Bereich 13 verbunden. Ebenso ist der zweite Anschlussstreifen 12 mittels zweier Verbindungsstege 12a, 12b mit dem rahmenartigen Bereich 13 verbunden.

Figur 2 zeigt einen vergrößerten Ausschnitt A des Anschlussrahmenverbunds. Es ist zu sehen, dass die beiden Anschlusstreifen 11, 12 infolge eines weiteren Verfahrensschrittes eine Krümmung aufweisen. Die Krümmung wird insbesondere durch Biegen der beiden Anschlussstreifen 11, 12 erzeugt. Die Krümmung führt zu einer abgewinkelten Form der beiden Anschlusstreifen 11, 12, wobei jeweils ein erster Abschnitt 11c, 12c quer zu einem zweiten Abschnitt (nicht dargestellt) verläuft.

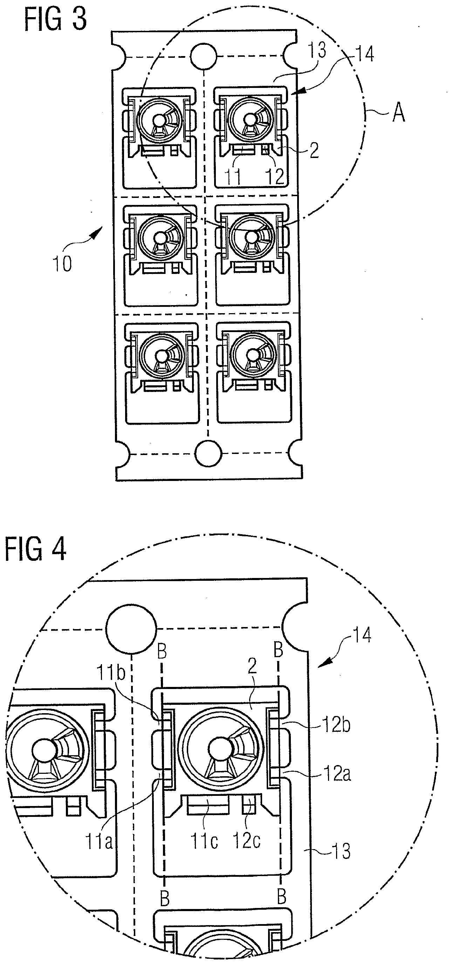

In einem nächsten Schritt (vergleiche Figur 3) wird der Gehäusekörper 2 hergestellt. Insbesondere werden mehrere Gehäusekörper 2 im Verbund hergestellt. Das verbindende Element ist hierbei der Anschlussrahmenverbund 10 mit seinen zusammenhängenden Anschlussrahmen 14. In den ausgestanzten Öffnungen 15 eines jeden Anschlussrahmens 14 wird jeweils ein Gehäusekörper 2 so angeordnet, dass die beiden Anschlusstreifen 11, 12 teilweise in den Gehäusekörper eingebettet sind.

Vorzugsweise werden die Gehäusekörper 2 spritzgegossen. Hierfür wird eine Spritzgussmaschine mit mehreren formgebenden Vorrichtungen verwendet (nicht dargestellt). Die formgebenden Vorrichtungen schließen im Bereich der ersten Abschnitte 11c, 12c. Figur 4 zeigt einen vergrößerten Ausschnitt A des in Figur 3 dargestellten Verbunds, in dem die ersten Abschnitte 11c, 12c besser zu sehen sind.

Da die Anschlussstreifen 11, 12 bereits vor der Herstellung der Gehäusekörper 2 gebogen werden, gäbe es im gekrümmten Bereich der Anschlussstreifen 11, 12 Probleme beim Schließen der jeweiligen Vorrichtung, wenn nicht die ersten Abschnitte 11c, 12c vorhanden wären. Diese erstrecken sich in der Ebene, wo die Vorrichtung schließt, und ermöglichen somit eine ordentliche Abdichtung der Vorrichtung beim Befüllen mit Gehäusekörpermasse.

Nach dem Aushärten der Gehäusekörpermasse wird der Verbund aus der Spritzgussmaschine herausgenommen. Der Verbund wird entlang der Trennlinien B zerteilt. Hierbei werden die ersten und zweiten Anschlussstreifen 11, 12 an den Verbindungsstegen 11a, 11b, 12a, 12b vom rahmenartigen Bereich 13 abgetrennt. Somit sind die ersten und zweiten Anschlussstreifen 11, 12 nicht mehr miteinander verbunden. Ein Halbleiterchip, der im Gehäuse angeordnet wird, kann mittels der beiden Anschlussstreifen 11, 12 elektrisch versorgt werden.

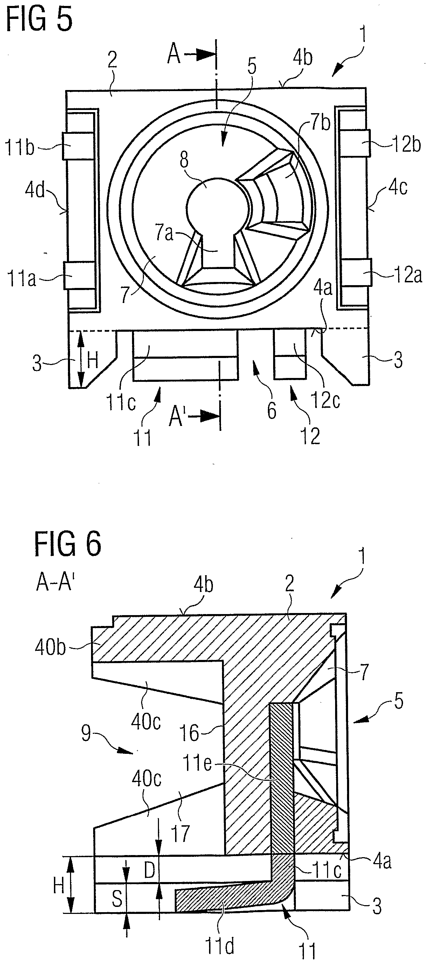

Figur 5 zeigt eine schematische Draufsicht der Vorderseite eines Gehäuses 1, das vorzugsweise gemäß dem im Zusammenhang mit den Figuren 1 bis 4 geschilderten Verfahren hergestellt wird.

Das Gehäuse 1 weist einen Gehäusekörper 2 sowie einen ersten Anschlussstreifen 11 und einen zweiten Anschlussstreifen 12 auf. Eine erste Seitenfläche 4a des Gehäusekörpers 2 ist quer zur Vorder- und Rückseite des Gehäusekörpers 2 angeordnet. Die beiden Anschlussstreifen 11, 12 verlaufen teilweise innerhalb des Gehäusekörpers 2 und sind an der ersten Seitenfläche 4a aus dem Gehäusekörper 2 herausgeführt. Außerhalb des Gehäusekörpers 2 sind die beiden Anschlussstreifen 11, 12 derart abgewinkelt, dass sie jeweils einen ersten Abschnitt 11c, 12c, der sich quer, vorzugsweise senkrecht, zur ersten Seitenfläche 4a erstreckt, und jeweils einen zweiten Abschnitt 11d (vergleiche Figur 6) aufweisen, der sich in einem Abstand D (vergleiche Figur 6) entlang der ersten Seitenfläche 4a, vorzugsweise parallel oder in einem Winkel von weniger als 2°zur ersten Seitenfläche 4, erstreckt.

Das Gehäuse 2 weist auf der Seite der beiden Anschlussstreifen 11, 12 Stützelemente 3 auf, die aus der Ebene der Seitenfläche 4a herausragen. Die Stützelemente 3 sind vorzugsweise ein Teil des Gehäusekörpers 2. Sie dienen zur Abstützung des Gehäuses. Das Gewicht des Gehäuses lastet somit nicht auf den beiden Anschlussstreifen 11, 12, sondern auf den Stützelementen 3. Um dies zu gewährleisten, weisen die Stützelemente 3 mit Vorteil eine Höhe H auf, die zumindest dem Abstand D plus der Dicke S (vergleiche Figur 6) der Anschlussstreifen 11, 12 entspricht. Ferner sind die Stützelemente 3 vorzugsweise nicht schmäler als ein Spalt 6 zwischen den beiden Anschlussstreifen 11, 12. Dies kann verhindern, dass sich die Stützelemente 3 eines Gehäuses in dem Spalt 6 eines anderen Gehäuses verhaken.

Der Gehäusekörper 2 weist eine zentrale Ausnehmung 5 auf, in welcher ein optoelektronischer Halbleiterchip angeordnet werden kann. Der Halbleiterchip kann auf einem Fortsatz 11e (vergleiche Figur 2) des ersten Anschlussstreifens 11 angeordnet werden. Der Fortsatz 11e befindet sich am Boden 8 der Ausnehmung 5 und ragt in diese hinein (in Figur 5 nicht dargestellt).

Die Innenwand 7 des Gehäusekörpers 2, welche die Ausnehmung 5 seitlich begrenzt, weist im Wesentlichen eine rotationssymmetrische Form und eine glatte Oberfläche auf. Lediglich im Bereich der beiden Anschlussstreifen 11, 12 ist die Innenwand 7 mit Vertiefungen 7a, 7b versehen, die einen Zugang zu den beiden Anschlussstreifen 11, 12 verschaffen. Insbesondere der durch die Vertiefung 7b freigelegte Bereich des zweiten Anschlussstreifens 12 ist zur Anbringung eines Bonddrahtes vorgesehen. Der Bonddraht reicht dann vom zweiten Anschlussstreifen 12 bis zum Halbleiterchip, der am Boden 8 der Ausnehmung 5 angeordnet werden kann. Der Halbleiterchip wird vorzugsweise auf den in die Ausnehmung hineinragenden Fortsatz 11e des ersten Anschlussstreifens 11 gelötet. Der Halbleiterchip kann mittels des ersten und zweiten Anschlussstreifens 11, 12 elektrisch versorgt werden.

Im Gegensatz zur Ausnehmung 5 weist der Gehäusekörper 2 eine drehsymmetrische Grundform auf, wenn man allein die Grundform betrachtet, die sich durch eine Berandung mit der ersten Seitenfläche 4a, der zweiten Seitenfläche 4b sowie den quer dazu verlaufenden dritten und vierten Seitenflächen 4c, 4d ergibt.

Die Form der Innenwand 7 gleicht insbesondere der Mantelfläche eines Kegelstumpfes, der sich zur Vorderseite hin öffnet. Mit Vorteil wird für den Gehäusekörper 2 ein Material mit hoher Reflektivität verwendet, so dass die Innenwand 7 einen Reflektor darstellt. Insbesondere enthält der Gehäusekörper 2 ein weiß erscheinendes Material, vorzugsweise PPA.

An den dritten und vierten Seitenflächen 4c, 4d treten Reste der Verbindungsstege 11a, 11b, 12a, 12b aus dem Gehäusekörper 2 hervor. Die Reste sind beim Abtrennen des Gehäuses vom rahmenartigen Bereich 13 (vergleiche Figur 4) übrig geblieben.

Figur 6 zeigt eine Seitenansicht eines Schnitts des Gehäuses 1 entlang der Linie AA' (vergleiche Figur 5). Hier ist der Verlauf des ersten Anschlussstreifens 11 gut zu erkennen. Ein Teil des ersten Anschlussstreifens 11 verläuft innerhalb des Gehäusekörpers 2 und erstreckt sich von der Ausnehmung 5 bis zur ersten Seitenfläche 4a. Ein weiterer Teil des ersten Anschlussstreifens 11 ist außerhalb des Gehäusekörpers 2 angeordnet und lässt sich in den ersten und den zweiten Abschnitt 11c, 11d, die quer zueinander verlaufen, untergliedern.

Weiterhin geht aus Figur 6 hervor, dass der Gehäusekörper 2 auf der Rückseite einen Hohlraum 9 aufweist. Der Hohlraum 9 wird durch die Rückwand 16, die zweite und die dritte Seitenwand 40b, 40c sowie die vierte Seitenwand (nicht dargestellt) begrenzt. Die Ausbildung des Gehäusekörpers 2 mit dem Hohlraum 9 kann insbesondere bei der Anwendung eines Spritzgussverfahrens die Entstehung von einem Lunker verhindern.

Ein Ende des zweiten Abschnitts 11d des ersten Anschlussstreifens 11 sowie des zweiten Anschlussstreifens (nicht dargestellt) reicht in den Hohlraum 9 hinein. Somit kann noch nach der Montage des Gehäuses 1 auf einen Anschlussträger die Verbindung, insbesondere eine Lötverbindung, zwischen dem Gehäuse 1 und dem Anschlussträger von der Rückseite aus bearbeitet werden.

Die zweite Seitenwand 40b überragt den ersten Anschlussstreifen 11 und den zweiten Anschlussstreifen und bildet somit eine Art Überdachung, durch welche die Anschlussstreifen von oben geschützt sind.

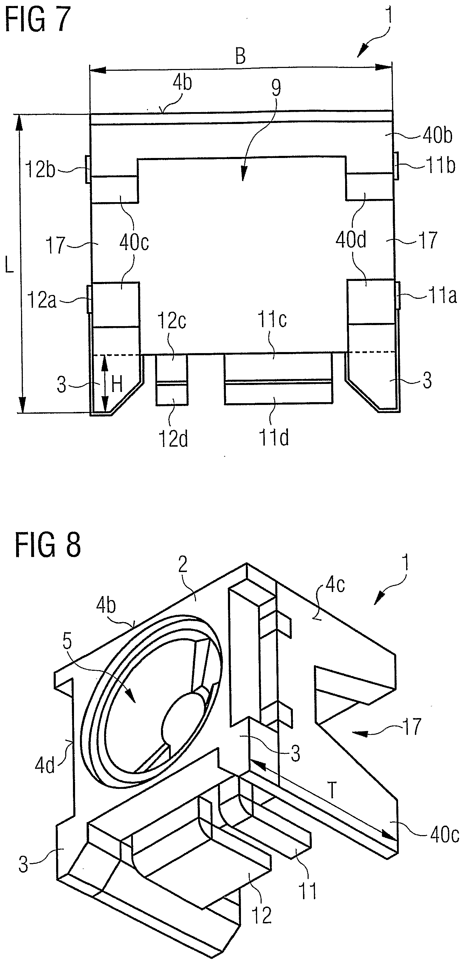

Figur 7 zeigt eine Draufsicht der Rückseite des in den Figuren 5 und 6 dargestellten Gehäuses 1. Wie zu sehen ist, sind die dritte Seitenwand 40c und die vierte Seitenwand 40d keine massiven Wände, sondern weisen Durchbrüche 17 auf. Die Durchbrüche 17 führen in den Hohlraum 9. Durch die Durchbrüche 17 und den Hohlraum 9 kann eine Halterung geschoben werden. Die Halterung kann das Gehäuse 1 beim Drahtbonden eines Halbleiterchips fixieren.

Figur 8 zeigt eine perspektivische Ansicht des in den Figuren 5 bis 7 dargestellten Gehäuses 1. Die Stützelemente 3 sind kufenartig ausgebildet und erstrecken sich entlang der dritten und vierten Seitenfläche 4c, 4d von der Vorderseite bis zur Rückseite des Gehäusekörpers 2.

Die zweite Seitenfläche 4b weist mit Vorteil eine quadratische Fläche auf, so dass beim Ansaugen des Gehäuses 1 keine Verkippungen zu befürchten sind.

Gemäß einer bevorzugten Ausführungsform weist das Gehäuse 1 folgende Maße auf: eine Breite B von 4,6 mm und eine Höhe L von 4,6 mm (vgl. Figur 7), außerdem eine Tiefe T von 3,8 mm (vergleiche Figur 8). Die Höhe H der Stützelemente kann 0,85 mm betragen.

Vorzugsweise werden Anschlussstreifen mit einer Dicke von 0,34 mm verwendet. Derartige Anschlussstreifen ermöglichen eine gute Wärmeabfuhr aus dem Gehäuse 1. Der größere Teil der Verlustwärme entsteht im Bereich des Halbleiterchips, das heißt im vorliegenden Fall im Bereich des ersten Anschlussstreifens 11. Daher ist der erste Anschlussstreifen 11 mit Vorteil breiter ausgebildet als der zweite Anschlussstreifen 12.

Bei einem seitlich emittierenden Bauelement wird in der Ausnehmung 5 ein Strahlung emittierender Halbleiterchip angeordnet (nicht dargestellt). Das Gehäuse 1 wird auf der Seite der beiden Anschlussstreifen 11, 12 auf einem Anschlussträger montiert. Die zweiten Abschnitte 11d, 12d erstrecken sich vorzugsweise entlang des Anschlussträgers und sind mit diesem elektrisch verbunden. Im Betrieb emittiert der Halbleiterchip Strahlung in eine Hauptabstrahlrichtung, die parallel zum vorzugsweise ebenen Anschlussträger verläuft.

Die Erfindung ist nicht durch die Beschreibung anhand der Ausführungsbeispiele auf diese beschränkt, sondern umfasst jede Kombination von Merkmalen, in den Patentansprüchen.

Diese Patentanmeldung beansprucht die Priorität der deutschen Patentanmeldung 102008048259.5.

## Patentansprüche

1. Gehäuse (1) für ein optoelektronisches Bauteil mit
- einem Gehäusekörper (2), der eine erste Seitenfläche (4a) aufweist, die quer zu einer Vorderseite und einer Rückseite des Gehäusekörpers (2) angeordnet ist, und
- einem ersten und zweiten zur elektrischen Versorgung eines optoelektronischen Halbleiterchips vorgesehenen elektrischen Anschlussstreifen (11, 12), die teilweise innerhalb des Gehäusekörpers (2) verlaufen, an der ersten Seitenfläche (4a) aus dem Gehäusekörper (2) herausgeführt sind und außerhalb des Gehäusekörpers (2) derart abgewinkelt sind, dass sie einen ersten Abschnitt (11c, 12c), der sich quer zur ersten Seitenfläche (4a) erstreckt, und einen zweiten Abschnitt (11d, 12d) aufweisen, der sich in einem Abstand (D) größer Null entlang der ersten Seitenfläche (4a) erstreckt,
**dadurch gekennzeichnet, dass** das Gehäuse (1) Stützelemente (3) aufweist, die mit dem Gehäusekörper (2) verbunden sind und aus der Ebene der Seitenfläche (4a) herausragen, wobei die Stützelemente (3) eine langgestreckte Form aufweisen und sich von der Vorderseite bis zur Rückseite des Gehäusekörpers (2) erstrecken und wobei die Stützelemente (3) einen tunnelartigen Hohlraum ausbilden, in welchem sich die Anschlussstreifen (11, 12) befinden, wobei
die Anschlussstreifen zwischen den Stützelementen (3) angeordnet sind, und die Stützelemente (3) parallel zu den zweiten Abschnitten (11d, 12d) der Anschlussstreifen (11, 12) verlaufen.

2. Gehäuse (1) nach dem vorherigen Anspruch,
wobei der Abstand (D) zwischen der ersten Seitenfläche (4a) und den zweiten Abschnitten (11d, 12d) der Anschlussstreifen (11, 12) zwischen 0,4 mm und 0,6 mm groß ist.

3. Gehäuse (1) nach einem der vorhergehenden Ansprüche, wobei der erste und der zweite Abschnitt (11c, 11d, 12c, 12d) einen Winkel einschließen, der größer ist als 90°.

4. Gehäuse (1) nach einem der vorhergehenden Ansprüche, wobei die Anschlussstreifen (11, 12) mindestens 0,2 mm dick sind.

5. Gehäuse (1) nach einem der vorhergehenden Ansprüche, wobei die Stützelemente (3) eine Höhe (H) aufweisen, die mindestens dem Abstand (D) der zweiten Abschnitte (11d, 12d) zur ersten Seitenfläche (4a) plus der Dicke (S) der Anschlussstreifen (11, 12) entspricht.

6. Gehäuse (1) nach einem der vorhergehenden Ansprüche, wobei der Gehäusekörper (2) eine parallel zur ersten Seitenfläche (4a) angeordnete zweite Seitenfläche (4b) mit quadratischer Form aufweist.

7. Gehäuse (1) nach einem der vorhergehenden Ansprüche, wobei der Gehäusekörper (2) eine quer zur ersten Seitenfläche (4a) angeordnete dritte und vierte Seitenwand (40c, 40d) aufweist, die jeweils mit einem Durchbruch (17) versehen sind.

8. Gehäuse (1) nach einem der vorhergehenden Ansprüche, wobei die Durchbrüche (17) in einen rückseitigen Hohlraum (9) des Gehäusekörpers (2) führen.

9. Gehäuse (1) nach einem der vorhergehenden Ansprüche, wobei die beiden Anschlussstreifen (11, 12) durch einen Spalt (6) voneinander getrennt sind, der kleiner ist als die Breite der Stützelemente (3).

10. Gehäuse (1) nach einem der vorhergehenden Ansprüche, wobei der Gehäusekörper (2) auf der Vorderseite eine Ausnehmung (5) aufweist, die zur Aufnahme des optoelektronischen Halbleiterchips vorgesehen ist.

11. Gehäuse (1) nach einem der vorhergehenden Ansprüche, wobei ein innerhalb des Gehäusekörpers (2) verlaufender Fortsatz (11e) des ersten Anschlussstreifens (11) in die Ausnehmung (5) hineinragt.

12. Seitlich emittierendes Bauteil mit einem Gehäuse (1) nach einem der vorhergehenden Ansprüche und einem innerhalb des Gehäusekörpers (2) angeordneten Strahlung emittierenden Halbleiterchip, wobei das Bauteil auf einem Anschlussträger angeordnet ist derart, dass sich die zweiten Abschnitte (11d, 12d) der Anschlussstreifen (11, 12) entlang des Anschlussträgers erstrecken, und durch ein elektrisch leitendes Fügemittel mit dem Anschlussträger verbunden sind.

13. Verfahren zur Herstellung eines Gehäuses (1) nach einem der vorhergehenden Ansprüche mit den Schritten:
- Einbringen eines Anschlussrahmens (14) mit einem ersten und einem zweiten ebenen Anschlussstreifen (11, 12) in eine formgebende Vorrichtung, wobei jeweils ein erster und ein zweiter Abschnitt (11c, 11d, 12c, 12d) der Anschlussstreifen (11, 12) aus der Vorrichtung herausragen,
- Befüllen der Vorrichtung mit einer Gehäusekörpermasse zur Ausbildung des Gehäusekörpers (2) derart, dass die Anschlussstreifen (11, 12) zumindest teilweise in die Gehäusekörpermasse eingebettet werden, wobei
die Anschlussstreifen (11, 12) vor oder nach der Fertigstellung des Gehäusekörpers (2) mit einer Krümmung versehen werden, so dass jeweils der erste Abschnitt (11c, 12c) quer zum zweiten Abschnitt (11d, 12d) verläuft und sich der zweite Abschnitt (11d, 12d) in einem Abstand (D) größer Null entlang der ersten Seitenfläche (4a) des Gehäusekörpers (2) erstreckt und **gekennzeichnet durch**
- Bereitstellen von Stützelementen (3), die mit dem Gehäusekörper (2) verbunden sind und aus der Ebene der Seitenfläche (4a) herausragen, wobei die Stützelemente (3) eine langgestreckte Form aufweisen und sich von der Vorderseite bis zur Rückseite des Gehäusekörpers (2) erstrecken und wobei die Stützelemente (3) einen tunnelartigen Hohlraum ausbilden, in welchem sich die Anschlussstreifen (11, 12) befinden, wobei die Anschlussstreifen zwischen den Stützelementen (3) angeordnet sind, und die Stützelemente (3) parallel zu den zweiten Abschnitten der Anschlussstreifen (11, 12) verlaufen.

14. Verfahren nach Anspruch 13,
wobei der Gehäusekörper (2) mittels eines Spritzgussverfahrens aus einem Thermoplastmaterial hergestellt wird.

## Claims

1. A housing (1) for an optoelectronic component having
- a housing body (2), which comprises a first side face (4a), which is arranged at an angle to a front and a back of the housing body (2), and
- first and second electrical terminal strips (11, 12) for supplying an optoelectronic semiconductor chip with electricity, which strips extend in part inside the housing body (2), are guided out of the housing body (2) at the first side face (4a) and are bent outside the housing body (2) in such a way that they comprise a first portion (11c, 12c), which extends at an angle to the first side face (4a), and a second portion (11d, 12d), which extends with a spacing (D) greater than zero along the first side face (4a),
**characterized in that**,
the housing (1) comprises supporting elements (3) which are connected to the housing body (2) and project out of the plane of the first side face (4a), wherein
the supporting elements (3) have an elongate shape and extend from the front to the back of the housing body (2) and wherein the supporting elements (3) form a tunnel-like cavity, in which the terminal strips (11, 12) are located, wherein
the terminal strips (11, 12) are arranged between the supporting elements (3), and the supporting elements (3) extend parallel to the second portions (11d, 12d) of the terminal strips (11, 12).

2. A housing (1) according to the preceding claim,
wherein the spacing (D) between the first side face (4a) and the second portions (11d, 12d) of the terminal strips (11, 12) is between 0.4 mm and 0.6 mm in size.

3. A housing (1) according to any of the preceding claims,
wherein the first and second portions (11c, 11d, 12c, 12d) form an angle which is greater than 90°.

4. A housing (1) according to any one of the preceding claims,
wherein the terminal strips (11, 12) are at least 0.2 mm thick.

5. A housing (1) according to any one of the preceding claims,
wherein the supporting elements (3) have a height (H) which corresponds at least to the spacing (D) of the second portions (11d, 12d) from the first side face (4a) plus the thickness (S) of the terminal strips (11, 12).

6. A housing (1) according to any one of the preceding claims,
wherein the housing body (2) comprises a second, square-shaped side face (4b) arranged parallel to the first side face (4a).

7. A housing (1) according to any one of the preceding claims,
wherein the housing body (2) comprises a third and fourth side wall (40c, 40d) arranged at an angle to the first side face (4a), which third and fourth side walls (40c, 40d) are each provided with an opening (17).

8. A housing (1) according to any one of the preceding claims,
wherein the openings (17) lead into a rear cavity (9) in the housing body (2).

9. A housing (1) according to any one of the preceding claims,
wherein the two terminal strips (11, 12) are separated from one another by a gap (6) which is smaller than the width of the supporting elements (3).

10. A housing (1) according to any one of the preceding claims,
wherein the housing body (2) comprises a recess (5) at the front, which is provided for accommodating the optoelectronic semiconductor chip.

11. A housing (1) according to any one of the preceding claims,
wherein an extension (11e) of the first terminal strip (11) extending inside the housing body (2) projects into the recess (5).

12. A side emitting component having a housing (1) according to any one of the preceding claims and a radiation emitting semiconductor chip arranged inside the housing body (2),
wherein the component is arranged on a terminal carrier in such a way that the second portions (11d, 12d) of the terminal strips (11, 12) extend along the terminal carrier and are connected to the terminal carrier by an electrically conductive joining agent.

13. A method of producing a housing (1) according to any one of the preceding claims, having the following steps:
- introducing a terminal frame (14) with a first and a second flat terminal strip (11, 12) into a shaping device, a first and a second portion (11c, 11d, 12c, 12d) of the terminal strips (11, 12) in each case projecting out of the device,
- filling the device with a housing body compound for forming the housing body (2), in such a way that the terminal strips (11, 12) are at least partially embedded in the housing body compound,
wherein the terminal strips (11, 12) are provided with a bend before or after completion of the housing body (2), such that in each case the first portion (11c, 12c) extends at an angle to the second portion (11d, 12d) and the second portion (11d, 12d) extends with a spacing (D) greater than zero along the first side face (4a) of the housing body (2), **characterized in that**,
- providing supporting elements (3) which are connected to the housing body (2) and project out of the plane of the first side face (4a), wherein
the supporting elements (3) have an elongate shape and extend from the front to the back of the housing body (2) and wherein the supporting elements (3) form a tunnel-like cavity, in which the terminal strips (11, 12) are located,
wherein
the terminal strips (11, 12) are arranged between the supporting elements (3), and the supporting elements (3) extend parallel to the second portions (11d, 12d) of the terminal strips (11, 12).

14. A method according to claim 13,
wherein the housing body (2) is made from a thermoplastic by means of an injection moulding method.

## Revendications

1. Boîtier (1) destiné à un composant optoélectronique, comportant
- un corps de boîtier (2) présentant une première face latérale (4a) disposée transversalement à une face avant et à une face arrière du corps de boîtier (2), et
- des première et seconde zones de connexion (11, 12) électriques destinées à alimenter une puce semi-conductrice optoélectronique en courant et s'étendant partiellement à l'intérieur du corps de boîtier (2), sortant du corps de boîtier (2) sur la première face latérale (4a) et coudées à l'extérieur du corps de boîtier (2) de manière à comporter une première portion (11c, 12c) s'étendant transversalement à la première face latérale (4a) et une seconde portion (11d, 12d) s'étendant à une distance (D) supérieure à zéro le long de la première face latérale (4a),
**caractérisé en ce que** le boîtier (1) comprend des éléments de support (3) reliés au corps de boîtier (2) et faisant saillie hors du plan de la première face latérale (4a), les éléments de support (3) ayant une forme allongée et s'étendant depuis la face avant jusqu'à la face arrière du corps de boîtier (2), les éléments de support (3) définissant une cavité sous forme de tunnel dans lequel se trouvent les zones de connexion (11, 12),
les zones de connexion étant disposées entre les éléments de support (3), les éléments de support (3) s'étendant parallèlement aux secondes portions (11d, 12d) des zones de connexion (11, 12).

2. Boîtier (1) selon la revendication précédente dans lequel la distance (D) entre la première face latérale (4a) et les deuxièmes portions (11d, 12d) des zones de connexion (11, 12) est comprise entre 0,4 mm et 0,6 mm.

3. Boîtier (1) selon l'une des revendications précédentes, dans lequel les première et seconde portions (11c, 11d, 12c, 12d) délimitent un angle supérieur à 90°.

4. Boîtier (1) selon l'une des revendications précédentes, dans lequel l'épaisseur des zones de connexion (11, 12) est au moins de 0,2 mm.

5. Boîtier (1) selon l'une des revendications précédentes, dans lequel les éléments de support (3) présentent une hauteur (H) correspondant au moins à la distance (D) des secondes portions (11d, 12d) par rapport à la première face latérale (4a) majorée de l'épaisseur (S) des zones de connexion (11, 12).

6. Boîtier (1) selon l'une des revendications précédentes, dans lequel le corps de boîtier (2) présente une seconde face latérale (4b) de forme carrée disposée parallèlement à la première face latérale (4a).

7. Boîtier (1) selon l'une des revendications précédentes, dans lequel le corps de boîtier (2) présente des troisième et quatrième parois latérales (40c, 40d) agencées transversalement à la première face latérale (4a) pourvues chacune d'une percée (17).

8. Boîtier (1) selon l'une des revendications précédentes, dans lequel les percées (17) aboutissent dans un espace vide arrière (9) du corps de boîtier (2).

9. Boîtier (1) selon l'une des revendications précédentes, dans lequel les deux zones de connexion (11, 12) sont séparées l'une de l'autre par un interstice (6) inférieur à la largeur des éléments de support (3).

10. Boîtier (1) selon l'une des revendications précédentes, dans lequel le corps de boîtier (2) présente, sur la face avant, un évidement (5) destiné à recevoir la puce semi-conductrice optoélectronique.

11. Boîtier (1) selon l'une des revendications précédentes, dans lequel une extension (lle) s'étendant à l'intérieur du corps de boîtier (2) de la première zone de connexion (11) fait saillie dans l'évidement (5).

12. Composant latéralement émetteur comportant un boîtier (1) selon l'une des revendications précédentes et une puce semi-conductrice agencée à l'intérieur du corps de boîtier (2) émettant un rayonnement, dans lequel le composant est agencé sur un support de connexion de sorte que les secondes portions (11d, 12d) des zones de connexion (11, 12) s'étendent le long du support de connexion et sont reliées par un agent de jonction électriquement conducteur au support de connexion.

13. Procédé de fabrication d'un boîtier (1) selon l'une des revendications précédentes, comportant les étapes suivantes :
- insertion d'un cadre de connexion (14) comportant des première et seconde zones de connexion (11, 12) plates dans un dispositif de mise en forme, une première et une deuxième portion (11c, 11d, 12c, 12d) des zones de connexion (11, 12) faisant chacune saillie du dispositif,
- remplissage du dispositif par une masse de corps de boîtier pour former le corps de boîtier (2) de telle sorte que les zones de connexion (11, 12) soient au moins partiellement noyées dans la masse de corps de boîtier, les zones de connexion (11, 12) étant pourvues avant ou après l'achèvement du corps de boîtier (2) d'une courbure, de sorte que la première portion (11c, 12c) s'étende chacune transversalement à la seconde portion (11d, 12d) et que la seconde portion (11d, 12d) s'étende dans une distance (D) supérieure à zéro le long de la première face latérale (4a) du corps de boîtier (2), et **caractérisé par**
- la mise à disposition d'éléments de support (3) reliés au corps de boîtier (2) et faisant saillie du plan de la face latérale (4a), les éléments de support (3) ayant une forme allongée et s'étendant depuis la face avant jusqu'à la face arrière du corps de boîtier (2), les éléments de support définissant un espace vide sous forme de tunnel dans laquelle sont disposées les zones de connexion (11, 12), les zones de connexion étant disposées entre les éléments de support (3), les éléments de support (3) s'étendant parallèlement aux secondes portions des zones de connexion (11, 12).

14. Procédé selon la revendication 13, dans lequel le corps de boîtier (2) est réalisé en mettant en oeuvre un procédé de moulage par injection à partir d'un matériau thermoplastique.
